# EUROPEAN PATENT APPLICATION

(11) **EP 0 880 183 A2**
(43) Date of publication of application: **25.11.1998**
(21) Application number: 98201648.7
(22) Date of filing: 14.05.1998
(51) Int. Cl.: H01L 29/78, H01L 21/336

(54) **LDMOS power device**

(30) Priority: 23.05.1997 US 47474 P
(71) Applicant: TEXAS INSTRUMENTS INCORPORATED, Dallas, TX 75265 (US)
(72) Inventor: Tsai, Chin-yu, Plano, TX 75023 (US); Efland, Taylor Rice, Richardson, TX 75082 (US); Erdeljac, John P., Plano, TX 75025 (US); Mitros, Jozef C., Richardson, TX 75081 (US); Hutter, Louis Nicholas, Richardson, TX 75082 (US)
(74) Representative: Holt, Michael

(57) **Abstract**

A LDMOS transistor (10) having a reduced surface drain (RSD) region (15), but otherwise similar to a conventional planar LDMOS transistor. The RSD region (15) is used to space the drain region (17) from the gate (14). It is formed after the polysilicon process used to form gate (14) (FIGURE 5), and is therefore self-aligning with respect to the gate (14). The process used to form the transistor (10) is compatible with the process used for existing planar LDMOS devices.

## Description

### TECHNICAL FIELD OF THE INVENTION

This invention relates to semiconductor devices, and more particularly, to an LDMOS (lateral double-diffused metal oxide semiconductor) device.

### BACKGROUND OF THE INVENTION

Battery-operated electronic systems such as notebook personal computers, personal digital assistants, and wireless communication devices often use power MOS (metal oxide semiconductor) devices as low on-resistance electronic switches for distributing battery power. For battery-operated applications, low on-resistance can be particularly important to ensure as little power consumption to the battery as possible. This ensures long battery life.

DMOS devices are "double diffused" MOS devices. An DMOS device has a source region and a back gate region, which are diffused at the same time. The back gate region is sometimes referred to as a Dwell (double diffused well) region. The channel is formed by the difference in the two diffusions, rather than by separate implantation. DMOS devices have the advantage of decreasing the length of the channels, thus providing low-power dissipation and high-speed capability.

DMOS devices may have either lateral or vertical configurations. A DMOS device having a lateral configuration (referred to herein as an LDMOS), has its source and drain at the surface of the semiconductor wafer. Thus, the current is lateral. Desired characteristics of an LDMOS are a high breakdown voltage, BV, and a low specific on-resistance.

### SUMMARY OF THE INVENTION

One aspect of the invention is an LDMOS transistor having a reduced surface drain (RSD) region. The transistor is fabricated on a semiconductor wafer with a first region of a first conductivity type, for example an p type. A second region of a second conductivity type, for example an n type, is formed as a well in the first semiconductor region. A third region of the first conductivity type is formed as a well in the second region.

A source region of the second conductivity type is then formed in the third region, drain region of the second conductivity type is formed in the second region and is spaced apart from the source region. An RSD region of the second conductivity type is formed in the second region between the source region and the drain region and adjacent to the drain region. This RSD region has a dopant concentration less than that of the drain region. Also, the RSD region is spaced apart from the source region, such that the third region forms a channel between the RSD region and the source region. A gate extends over this channel and over at least part of the source region, and at least part of the RSD region. A backgate region of the first conductivity type is formed in the third region adjacent to the source region, such that the source region separates the backgate region and the channel.

The RDS LDMOS transistor of the present invention is well suited for hard disk drive and RF applications. It provides good breakdown voltage characteristics. The process complexity is reduced and thermal stability is good, compared to other LDMOS devices that have attempted to improve breakdown voltage, such as resurface drain extended (RSRF) LDMOS devices.

Testing has shown that the transistor is capable of Rsp = 0.39 m.ohm.cm² and BV = 24.4 volts. This compares favorably to conventional planar LDMOS devices, where Rsp = 0.59 m.ohm.cm² and BV = 18 - 20 volts. The Rsp measurements are with 3 MV/cm gate stress, Vgs = 12.75 volts, and Tox = 425 angstroms.

As compared to shallow Nwell (LV Nwell) LDMOS devices, which are another LDMOS variation, RDS LDMOS devices enable a smaller pitch, using a solid well rather than a donut-shaped well. Its lightly doped drain region is self aligned to the gate polysilicon layer, which ensures process stability. The RSD region allows smaller layer geometry, and offers good conductance at the surface.

In general, the RSD LDMOS device of the present invention is desirable because of its adherence to the conventional device structure and process. At the same time, it offers good Rsp versus BV performance characteristics.

### BRIEF DESCRIPTION OF THE DRAWINGS

The present invention will now be further described, by way of example, with reference to the accompanying drawings in which:
FIGURE 1 is a cross sectional elevational view of an RSD LDMOS transistor in accordance with the invention;
FIGUREs 2 - 7 are cross sectional elevational views of a semiconductor wafer during various stages of fabrication, resulting in the RSD LDMOS transistor of FIGURE 1;
FIGURE 8 is a graph illustrating Rsp as a function of the resistive path, L+Ld of FIGURE 1, with Ld varied;
FIGURE 9 is a graph illustrating BV as a function of the resistive path, L+Ld of FIGURE 1, with Ld varied;
FIGURE 10 is a graph illustrating both Rsp and BV as a function of the resistive path, L+Ld of FIGURE 1, with L varied; and
FIGURE 11 is a graph illustrating Rsp with respect to a normalized gate voltage.

### DETAILED DESCRIPTION OF THE INVENTION

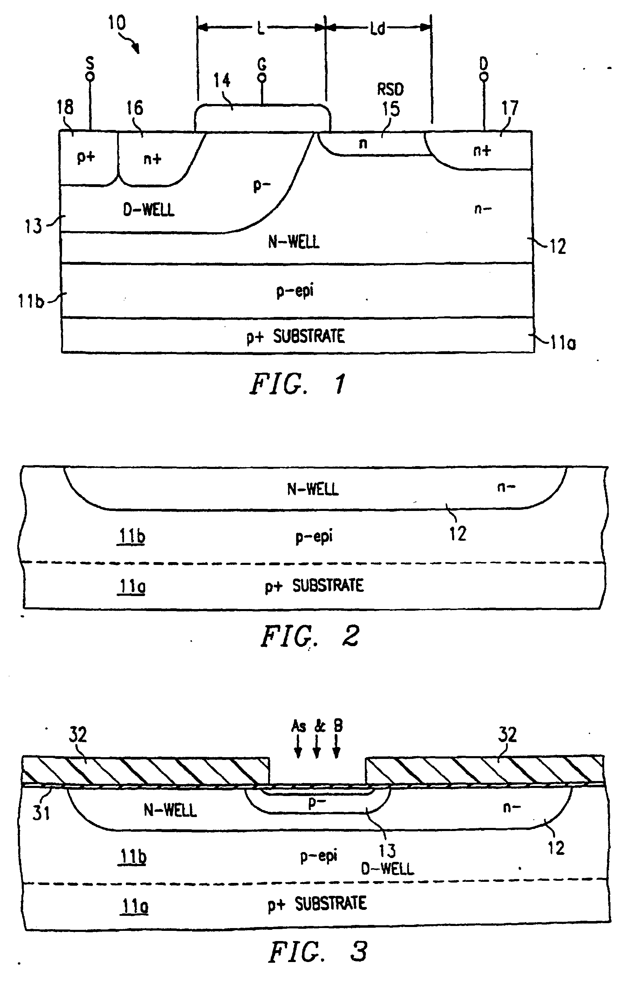

FIGURE 1 is a cross-sectional elevational view of an reduced surface drain (RSD) LDMOS transistor 10 in accordance with the invention. Transistor 10 has a reduced surface drain (RSD) region 15, but is otherwise similar to a planar type LDMOS device. Although not shown in FIGURE 1, a thin oxide layer under gate 14 does not have thick field oxide regions between source regions 16 and drain regions 17 as do non-planer LDMOS devices.

As explained below in connection with FIGUREs 2 - 7, the RSD region 15 is self aligned to the polysilicon used for gate 14. Transistor 10 is formed with an optimized double diffusion for low voltage and is self-isolated by a high-voltage Nwell 12 and the RSD region 15. Additionally, the drain region 17 is spaced back from gate 14. The result is enhanced breakdown voltage, in the range of 15 - 35 volts. The RSD region 15 enhances specific ON-resistance (Rsp) as compared to other planar type LDMOS devices. The RSD region 15 has good conductance at the surface of transistor 10, providing a lightly doped drain for current flow at the on-state.

Fabrication of an LDMOS device, without the RSD region 15 of the present invention, is described in U.S. Patent No. 5,736,766, entitled "Medium Voltage LDMOS Device and Method of Fabrication", assigned to Texas Instruments Incorporated. Although the fabrication process describes a field oxide (non-planar) type LDMOS, the field oxide step can be omitted and many of the other processing steps are similar to those described below.

FIGUREs 2 - 7 are cross-sectional elevational views illustrating successive stages of fabrication of a semiconductor wafer, resulting in a die having numerous transistors 10. The fabrication process employs various known semiconductor fabrication techniques, such as photoresist patterning, and the deposition, implantation, and diffusion of various materials. The fabrication process is compatible with linear BiCMOS technology such as that developed by Texas Instruments Incorporated.

The specific steps of photoresist patterning, such as the deposition of oxide, nitride, and photoresist layers and their etching and removal, are not completely illustrated. Rather, it is assumed to be understood that these steps are used to provide exposed and masked areas on the surface of the wafer for the purpose of implanting or depositing material in the exposed areas.

As is the case with conventional LDMOS fabrication, each transistor 10 is built inside a high voltage Nwell. The gate oxide (moat) is defined all across the structure. No thick field oxide layers are used inside the device.

Referring to FIGURE 2, fabrication of a die having transistors 10 begins with the formation of an p-epitaxial layer 11b on a p+ substrate 11a. The p+ substrate 11a is typically a heavily doped p+ type silicon that is doped with material of a first conductivity type, such as boron. The p-epitaxial layer 11b is typically a lightly doped p-type silicon that is grown by vapor phase epitaxy, liquid metal epitaxy, or other suitable means.

It should be understood that in the example of this description, as is the case for MOS devices in general, the use of p and n type dopants may be reversed. In general, reference can be made to a p type dopant as having a first conductivity and an n type dopant as having a second conductivity, or vice versa.

Oxide and nitride layers (not explicitly shown) are then formed and patterned for implantation of an n-type material, such as phosphorus, antimony, or arsenic. This implant forms Nwell 12. The Nwell 12 is then diffused and the oxide and nitride are removed. The Nwell 12 is a high voltage, low concentration (n-), deep diffusion well. The Nwells 12 provide self-isolation for each transistor 10.

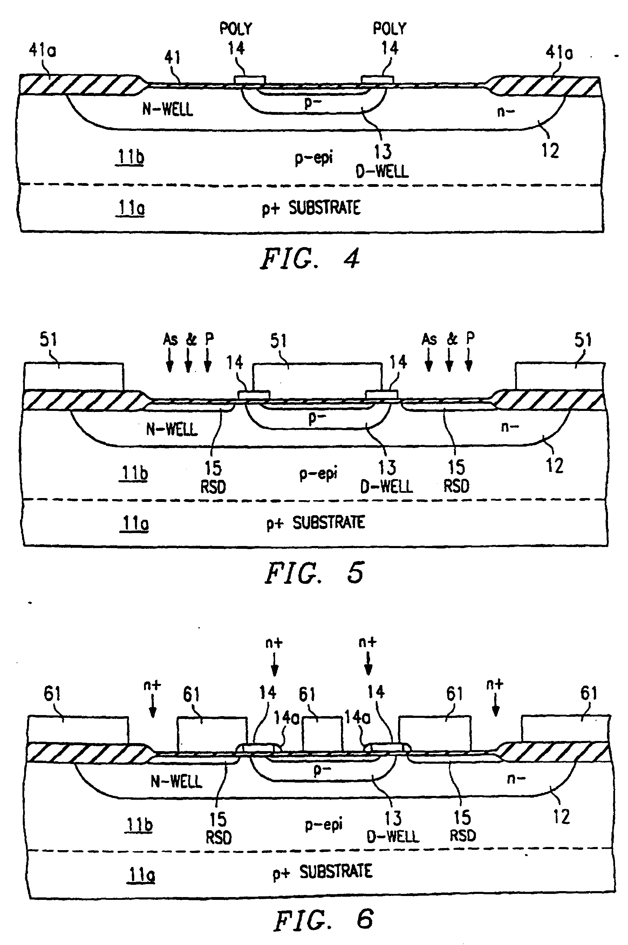

FIGURE 3 illustrates the formation of Dwells 13. A pad oxide layer 31 formed and a photoresist layer 32 is patterned and etched on the surface of the wafer. The pattern is used to expose areas at the surface, which are implanted with p and n type dopants and double-diffused to form low concentration (p-) Dwells 13. Oxide layer 31 and photoresist layer 32 are then removed. A threshold adjust layer (p- type) is implanted, resulting in the surface of the Nwell 12 being resistive and resulting in low ON-resistance for transistor 10.

The Dwell 13 of FIGURE 3 is a "solid" type Dwell. In other embodiments, Dwells 13 could have a "donut" (toroidal) configuration.

FIGURE 4 illustrates the formation of the gate oxide layer 41 and gates 14. An oxide layer 41 is formed and patterned nitride is used to expose areas in which thick field oxide regions and a nitride layer 41a are grown. Next, a gate oxide is grown and a polysilicon layer is deposited and etched using patterned photoresist (not shown) to expose certain regions that will become gates 14. The photoresist is then removed, leaving gates 14.

FIGURE 5 illustrates the formation of the RSD regions 15. Appropriate patterning of a photoresist layer 51 is used to mask and expose desired areas on the surface of the wafer. The exposed areas are implanted with a shallow co-implant of materials having n type conductivity, specifically, arsenic and phosphorus. The "co-implant" is through the same mask, although not necessarily at the same time. A typical depth of RSD regions 18 is 0.3 micrometers. No thermal cycle is performed with respect to RSD regions 15. The RSD regions 15 provide reduced surface penetration, a reduced surface field adjacent to the gates 14, and reduced surface resistance in the drain region 17.

Because RSD regions 15 are implanted after the polysilicon process used to form gates 14, they are self-aligned with respect to gates 14. Also, the RSD regions 15 can be used to terminate the Dwell regions 13. This is important because the mask used for the Dwell implantation has the potential for misalignment with the mask used for the gate formation process. Shorter gate width is achievable, which improves ON-resistance.
FIGURE 6 illustrates sidewalls 14a on gates 14 and the n+ implantation for source regions 16 and drain regions 17. Sidewalls 14a may be formed using conventional sidewall techniques. For source regions 16 and drain regions 17, a photoresist layer 61 is patterned and etched, exposing source regions 16 and drain regions 17. These regions are implanted with an n type dopant and diffused, with RSD regions 15 being diffused at the same time. The implantation for source regions 16 and drain regions 17 is of higher concentration (n+) than that of RSD regions 15.

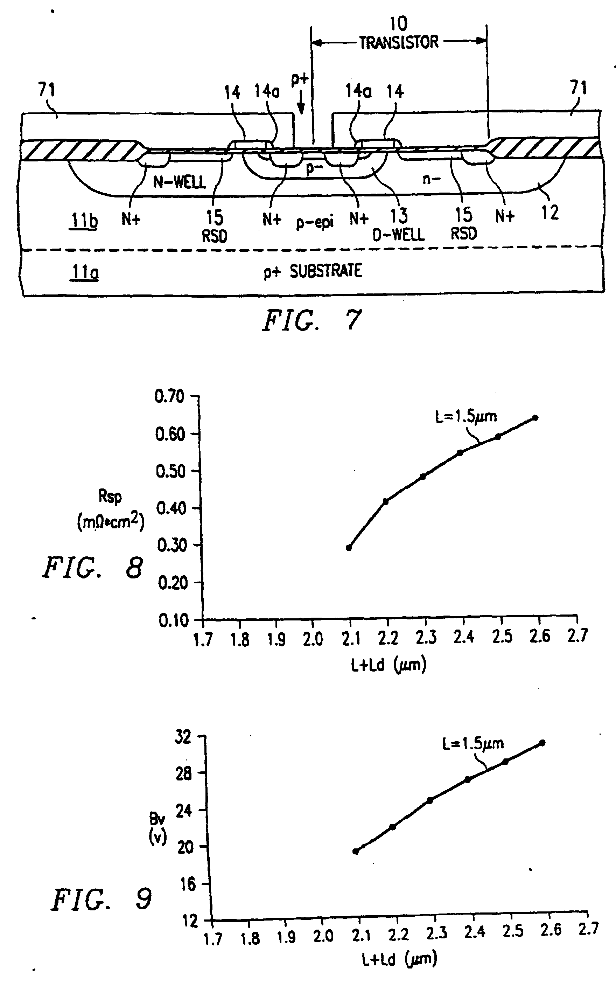

Finally, as illustrated in FIGURE 7, after appropriate patterning of photoresist layer 71, p+ backgate regions 18 are implanted and diffused. These p+ regions 18 are highly concentrated (p+) regions having a depth approximately the same as that of the n+ source regions 16 and drain regions 17. Alternatively, p+ regions 18 may be deeper than the n+ source regions 16 and n+ drain regions 17.

In other embodiments, it would possible to have the RSD layer in the source regions 16. This would be performed with a blanket implant of both RSD regions, but would not alter the configuration of FIGURE 1 due to subsequent implantation of the source region 16 and backgate region 18. The advantage of this approach is the elimination of a masking step.

As indicated by the dotted lines in FIGURE 7, the RSD LDMOS transistor 10 of FIGURE 1 is a portion of the circuitry formed by the process of FIGUREs 2 - 7. Appropriate metallization steps are performed to provide connections and contacts.

FIGURE 8 is a graph illustrating Rsp as a function of the length of the resistive path, which is the sum of the distances L (channel length) and Ld (drift length). These distances are illustrated in FIGURE 1. In FIGURE 8, Ld is varied, resulting in varying values of Rsp. Rsp is plotted as m·cm² , with Vg = 10 volts. The channel length, L, is 1.5 µm.
FIGURE 9 is a graph illustrating breakdown voltage, BV, as a function of L + Ld, where Ld is varied. Again, Vg = 10 volts and the channel length, L, is 1.5 µm.

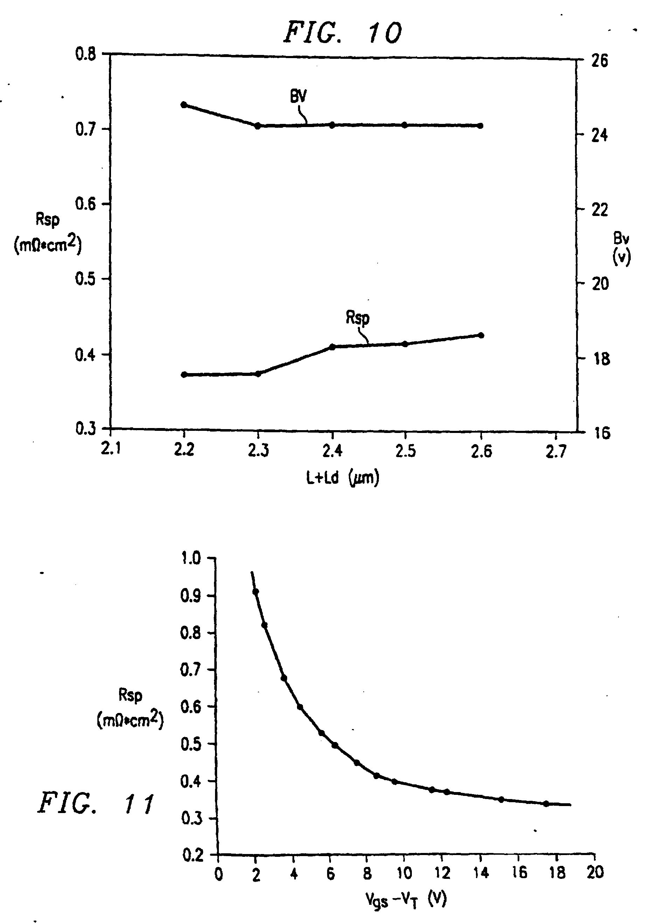

FIGURE 10 is a graph illustrating Rsp and BV as a function of Ld + L, where L is varied. The drift length, Ld, is 0.8µm. As in FIGUREs 8 and 9, Vg = 10 volts.

In general, as indicated by FIGUREs 8 - 10, RSD LDMOS transistor 10 favors more L and less Ld because reverse bias depletion extends more into the channel region. An optimized performance transistor 10 might have the following operating characteristics:
Rsp 0.39 m·cm²
Vgs= 12.75 volts
BV = 24.4 volts,
   , where the gate stress is 3MV/cm and the oxide thickness, Tox, = 425 angstroms.

FIGURE 11 is a graph that illustrates Rsp with respect to a normalized gate voltage, Vgs-Vt, where Tox is 425 angstroms and Vg = 10 volts. A targeted Vt is 1.6 volts.

Although the present invention has been described in detail, it should be understood that various changes, substitutions and alterations can be made hereto without departing from the spirit and scope of the invention as defined by the appended claims.

## Claims

1. A reduced surface drain (RSD) LDMOS transistor, comprising:
a first region of a first conductivity type;
a second region of a second conductivity type formed as a well in said first region;
a third region of said first conductivity type formed as a well in said second region
a source region of said second conductivity type formed in said third region;
a drain region of said second conductivity type formed in said second region and spaced apart from said source region, said drain region having a drain dopant concentration;
an RSD region of said second conductivity type formed in said second region between said source region and said drain region and adjacent to said drain region, said RSD region having a dopant concentration less than the dopant concentration of said drain region;
wherein said source region is spaced apart from said RSD region, such that said third region forms a channel between said source region and said RSD region;
a gate formed over at least part of said source region, said channel, and at least part of said RSD region; and
a backgate region formed in said third region and adjacent to said source region such that said source region separates said backgate region and said channel, said backgate region being of said first conductivity type.

2. The transistor of Claim 1 or Claim 2, wherein said first conductivity type is p type and said second conductivity is n type.

3. The transistor of Claim 1, wherein said semiconductor layer has a first sublayer having a first dopant concentration and a second sublayer having a second dopant concentration less than said first dopant concentration.

4. The transistor of any of Claims 1 to 3, wherein said source region has a dopant concentration greater than that of said second region.

5. The transistor of any of Claims 1 to 4, wherein said drain region has a dopant concentration greater than that of said second region.

6. The transistor of any of Claims 1 to 5, wherein said second region is a low dopant concentration high-voltage region.

7. The transistor of any of Claims 1 to 6, wherein said third region forms a low dopant concentration region.

8. The transistor of any of Claims 1 to 7, further comprising a gate oxide layer formed under said gate, said gate oxide layer being substantially planar over said transistor.

9. A method of fabricating an RSD LDMOS transistor, comprising the steps of:
forming a first region of a first conductivity type;
forming a second region of a second conductivity type, as a well in said semiconductor layer;
forming a third region of said first conductivity type, as a well in said second region;
forming a gate region over at least part of said third region;
forming an RSD region of said second conductivity type in said second region, such that a first side of said RSD region is substantially aligned with a first side of said gate region and said RSD region extends outwardly from said gate region;
forming a source region of said second conductivity type in said third region, said source region being under a second side of said gate region and spaced apart from said RSD region such that said third region forms a channel between said source region and said RSD region; and
forming a drain region of said second conductivity type in said second region, said drain region being spaced from said first side of said gate by said RSD region;
wherein said source region and said drain region have a dopant concentration that is greater than that of said RSD region.

10. The method of Claim 10, further comprising performing an RSD region such that said RSD region extends outwardly adjacent both sides of said gate region.
